# EUROPEAN PATENT SPECIFICATION

(11) **EP 3 159 943 B1**
(45) Date of publication and mention of the grant of the patent: **06.01.2021**
(21) Application number: 16194197.6
(22) Date of filing: 17.10.2016
(51) Int. Cl.: H01L 31/0687, H01L 31/078, H01L 31/05, H01L 31/0304

(54) **MULTIJUNCTION METAMORPHIC SOLAR CELL FOR SPACE APPLICATIONS**
METAMORPHISCHE MEHRFACHSOLARZELLE FÜR RAUMFAHRTANWENDUNGEN
CELLULE SOLAIRE MÉTAMORPHIQUE À JONCTIONS MULTIPLES POUR APPLICATIONS SPATIALES

(30) Priority: 19.10.2015 US 201562243239 P; 26.08.2016 US 201615249185
(43) Date of publication of application: 26.04.2017
(73) Proprietor: SolAero Technologies Corp., Albuquerque, NM 87123 (US)
(72) Inventor: DERKACS, Daniel, Albuquerque, New Mexico 87111 (US)
(74) Representative: adares Patent- und Rechtsanwälte Reininger & Partner GmbB

(56) References cited:
- US-A1- 2006 144 435
- US-A1- 2006 162 768
- US-A1- 2008 163 920
- US-A1- 2010 147 366
- US-A1- 2011 011 983
- US-A1- 2014 261 628
- L. M. Fraas ET AL: "34% Efficient InGaP/GaAs/GaSb Cell-Interconnected-Circuits for Line-Focus Concentrator Arrays", , October 2002 (2002-10), XP055109208, Retrieved from the Internet: URL:http://ntrs.nasa.gov/search.jsp?R=2003 0000588
- Daniel J. Aiken: "InGaP/GaAs/Ge multi-junction solar cell efficiency improvements using epitaxial germanium", Proceedings of 28th IEEE Photovoltaic Specialists Conference - 15-22 Sept. 2000 - Anchorage, AK, USA, 15 September 2000 (2000-09-15), pages 994-997, XP055614171, PISCATAWAY, NJ [US] DOI: 10.1109/PVSC.2000.916053 ISBN: 978-0-7803-5772-3
- David B. Jackrel ET AL: "Dilute nitride GaInNAs and GaInNAsSb solar cells by molecular beam epitaxy", Journal of Applied Physics, vol. 101, no. 11, 1 June 2007 (2007-06-01) , page 114916, XP055557863, US ISSN: 0021-8979, DOI: 10.1063/1.2744490
- R. R. King ET AL: "(Invited) Group-IV Subcells in Multijunction Concentrator Solar Cells", ECS Transactions, vol. 50, no. 9, 15 March 2013 (2013-03-15) , pages 287-295, XP055135598, ISSN: 1938-6737, DOI: 10.1149/05009.0287ecst

## Description

### BACKGROUND OF THE INVENTION

### Field of the Invention

The present disclosure relates to solar cells and the fabrication of solar cells, and more particularly the design and specification of a multijunction solar cell using electrically coupled but spatially separated semiconductor bodies based on III-V semiconductor compounds.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL).

The efficiency of energy conversion, which converts solar energy (or photons) to electrical energy, depends on various factors such as the design of solar cell structures, the choice of semiconductor materials, and the thickness of each cell. In short, the energy conversion efficiency for each solar cell is dependent on the optimum utilization of the available sunlight across the solar spectrum as well as the "age" of the solar cell, i.e. the length of time it has been deployed and subject to degradation associated with the space environment. As such, the characteristic of sunlight absorption in semiconductor material, also known as photovoltaic properties, is critical to determine the most efficient semiconductor to achieve the optimum energy conversion to meet customer requirements.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as its exposure to radiation in the ambient environment over time. Factors such as the short circuit current density (J_{sc}), the open circuit voltage (V_{oc}), and the fill factor are also important. Another parameter of consideration is the difference between the band gap and the open circuit voltage, or (E_{g}/q - V_{oc}), of a particular active layer, and such parameters may vary over time (i.e. during the operational life of the system). Accordingly, such parameters are NOT simple "result effective" variables (as discussed and emphasized below) to those skilled in the art confronted with complex design specifications and practical operational considerations.

One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters. The present application is directed to solar cells with several substantially lattice matched subcells, but including at least one subcell which is lattice mismatched, and in a particular embodiment to a five junction (5J) solar cell using electrically coupled but spatially separated four junction (4J) semiconductor bodies based on III-V semiconductor compounds.

US 2014/261628 A1, the article L.M. Fraas et A1: "34% Efficient InGAP/GaAs/GaSb Cell-Interconnected-Circuits for Line-Focus Concentrator Arrays", October 2002, XP055109208, US 2006/144435 A1 and US 2006/162768 A1 disclose a solar cell module including a terminal of first polarity and a terminal of second polarity comprising a first semiconductor body including a tandem vertical stack of at least a first upper, a second and third bottom solar subcells; and a second semiconductor body disposed adjacent and parallel to the first semiconductor body and including a tandem vertical stack of at least a first upper, a second and a third bottom solar subcells substantially identical to that of the first semiconductor body, the first upper subcell of the first and second semiconductor bodies having a top contact connected to the terminal of first polarity, the third bottom subcell of the second semiconductor body having a bottom contact connected to the terminal of second polarity, wherein the third subcell of the first semiconductor body is connected in a series electrical circuit with the third subcell of the second semiconductor body so that the interconnection of subcells of the first and second semiconductor bodies forms at least a four junction solar cell. "InGaP/GaAs/Ge multi-junction solar cell efficiency improvements using epitaxial germanium", Daniel J. Aiken, a paper in the Conference Record of the IEEE Photovoltaic Specialists Conference, published in February 2000, and R. R. King ET AL: "Group-IV Subcells in Multijunction Concentrator Solar Cells", ECS Transactions, vol. 50, no. 9, 15 March 2013, p.287-295, XP055135598 describe how the efficiency of a multi-junction solar cell and current matching can be improved using epitaxially grown Germanium. Finally, "Dilute nitride GaInNAs and GaInNAsSb solar cells by molecular beam epitaxy", David B Jackrel et al., published in Journal of Applied Physics, vol 101, no. 11, June 2007, page 114916, describes the growth and analysis of dilute nitride films, which have application for lattice matching in multi-junction solar cells.

### SUMMARY OF THE DISCLOSURE

### Objects of the Disclosure

It is an object of the present disclosure to provide increased photoconversion efficiency in a multijunction solar cell for space applications over the operational life of the photovoltaic power system.

It is another object of the present disclosure to provide in a multijunction solar cell in which the selection of the composition of the subcells and their band gaps maximizes the efficiency of the solar cell at a predetermined high temperature (in the range of 40 to 100 degrees Centigrade) in deployment in space at AM0 at a predetermined time after the initial deployment, such time being at least one year, and in the range of one to twenty-five years.

It is another object of the present disclosure to provide a four junction solar cell subassembly in which the average band gap of all four cells in the subassembly is greater than 1.44 eV, and to couple the subassembly in electrical series with at least one additional subcell in an adjacent solar cell subassembly.

It is another object of the present disclosure to provide a lattice mis-matched five junction solar cell in which the bottom subcell is intentionally designed to have a short circuit current that is substantially greater than current through the top three subcells when measured at the "beginning-of-life" or time of initial deployment.

It is another object of the present disclosure to provide a five-junction (5J) solar assembly assembled from two four-junction (4J) solar cell subassemblies so that the total current provided by the two subassemblies matches the total current handling capability of the bottom subcell of the assembly.

It is another object of the present disclosure to match the larger short circuit current of the bottom subcell of the solar cell assembly with two or three parallel stacks of solar subcells, i.e. a configuration in which the value of the short circuit current of the bottom subcell is at least twice, or at least three times, that of the solar subcells in each parallel stack which are connected in a series with the bottom subcell. Stated another way, given the choice of the composition of the bottom subcell, and there by the short circuit current of the bottom subcell, it is an object of the disclosure that the upper subcell stack be specified and designed to have a short circuit current which is one-half or less than that of the bottom subcell.

### Features of the Invention

The subject-matter of the present invention is defined in claim 1 (product) and in claim 11 (process). Briefly, and in general terms, the present disclosure describes solar cells that include a solar cell assembly of two or more solar cell subassemblies, each of which includes a respective monolithic semiconductor body composed of a tandem stack of solar subcells, where the subassemblies are interconnected electrically to one another.

As described in greater detail, the inventors of the present application have discovered that interconnecting two or more spatially split multi-junction solar cell subassemblies can be advantageous. The spatial split can be provided for multiple solar cell subassemblies monolithically formed on a single substrate. Alternatively, the solar cell subassemblies can be fabricated as separate semiconductor chips that can be coupled together electrically.

One advantage of interconnecting two or more spatially split multi-junction solar cell subassemblies is that such an arrangement can allow accumulation of the subcells in relatively few semiconductor bodies.

Further, selection of relatively high band gap semiconductor materials for the top subcells can provide for increased photoconversion efficiency in a multijunction solar cell for outer space or other applications over the operational life of the photovoltaic power system. For example, increased photoconversion efficiency at a predetermined time after initial deployment of the solar cell can be achieved.

Thus, in one aspect, a monolithic solar cell subassembly includes a first semiconductor body including an upper first solar subcell composed of (aluminum) indium gallium phosphide ((Al)InGaP); a second solar subcell disposed adjacent to and lattice matched to said upper first subcell, the second solar subcell composed of (aluminum) gallium arsenide ((Al)GaAs) or indium gallium arsenide phosphide (InGaAsP); and a bottom subcell lattice matched to said second subcell and composed of indium gallium arsenide (In)GaAs.

The aluminum (or Al) constituent element, or indium (or In), shown in parenthesis in the preceding formula means that Al or In (as the case may be) is an optional constituent, and in the case of Al, in this instance may be used in an amount ranging from 0% to 30%. The subcells are configured so that the current density of the upper first subcell and the second subcell have a substantially equal predetermined first value, and the current density of the bottom subcell is at least twice that of the predetermined first value.

In another aspect, the present disclosure provides a four or five junction solar cell assembly including a terminal of first polarity and a terminal of second polarity comprising: a first semiconductor body including a tandem vertical stack of at least a first upper solar subcell, a second solar subcell, and a bottom solar subcell, the first upper subcell having a top contact connected to the terminal of first polarity, and the bottom solar subcell having a top contact and a bottom contact; a second semiconductor body disposed adjacent to the first semiconductor body and including a tandem vertical stack of at least a first upper, a second and a bottom solar subcells, the first upper subcell of the second semiconductor body having a top contact connected to the terminal of first polarity, and the bottom subcell of the second semiconductor body having a top contact and a bottom contact with its bottom contact connected to the terminal of second polarity; wherein the first and second semiconductor body each comprises a first highly doped lateral conduction layer electrically connected to each other and disposed adjacent to and beneath the second solar subcell of each respective body, the first lateral conduction layer being compositionally graded so as to lattice match the lattice constant of the second solar subcell at the top, and the lattice constant of the bottom subcell of each respective body at the bottom, and wherein the first and second semiconductor body each comprises a blocking p-n diode or insulating layer disposed adjacent to and beneath the first highly doped lateral conduction layer; and a second highly doped lateral conduction layer disposed adjacent to and beneath the respective blocking p-n diode or insulating layer, an electrical connection between the first lateral conduction layer of the first and the second semiconductor body and the second lateral conduction layer of the first semiconductor body; the bottom solar subcell of each respective body being disposed adjacent to and beneath the second highly doped lateral conduction layer, with the bottom subcell of the first semiconductor body being connected in a series electrical circuit with the bottom subcell of the second semiconductor body so that at least a four junction solar cell is formed by the assembly.

In some embodiments, there further comprises a first electrical contact on the first lateral conduction layer, and a second electrical contact on the second lateral conduction layer, and wherein the electrical connection is a wire welded to the first electrical contact at one end, and the second electrical contact at the other end.

In some embodiments, there further comprises an electrical connection between the bottom contact of the first bottom subcell, and the top contact of the second bottom subcell.

In some embodiments, additional layer(s) may be added in the cell structure without departing from the scope of the claims.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, without departing from the scope of the claims.

### BRIEF DESCRIPTION OF THE DRAWINGS

The invention will be better and more fully appreciated by reference to the following detailed description when considered in conjunction with the accompanying drawings, wherein:
FIG. 1 is a graph representing the BOL value of the parameter E_{g}/q - V_{oc} at 28° C plotted against the band gap of certain ternary and quaternary materials defined along the x-axis;
FIG. 2 is a cross-sectional view of a first embodiment of a first semiconductor body including a four junction solar cell after several stages of fabrication including the growth of certain semiconductor layers on the growth substrate up to the contact layer and etching contact steps on lower levels according to the present disclosure;
FIG. 3 is a cross-sectional view of a first embodiment of a second semiconductor body including a four junction solar cell after several stages of fabrication including the growth of certain semiconductor layers on the growth substrate up to the contact layer, according to the present disclosure;
FIG. 4 is a cross-sectional view of an embodiment of a five junction solar cell after following electrical connection of the first and second semiconductor bodies according to the present disclosure; and
FIG. 5 is a schematic diagram of the five junction solar cell of FIG. 4.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells (as well as inverted metamorphic multijunction solar cells) are disclosed in the related applications noted above. Some, many or all of such features may be included in the structures and processes associated with the non-inverted or "upright" solar cells of the present disclosure. However, more particularly, the present disclosure is directed to the fabrication of a multijunction lattice matched solar cell grown over a metamorphic layer which is grown on a single growth substrate which forms a solar cell subassembly. More specifically, however, in some embodiments, the present disclosure relates to multijunction solar cell subassemblies with direct band gaps in the range of 2.0 to 2.15 eV (or higher) for the top subcell, and (i) 1.65 to 1.8 eV, and (ii) 1.41 eV for the middle subcells, and 0.6 to 0.8 eV direct or indirect band gaps, for the bottom subcell, respectively, and the connection of two or more such subassemblies to form a solar cell assembly.

As described in greater detail, the present application notes that interconnecting two or more spatially split multijunction solar cell subassemblies can be advantageous. The spatial split can be provided for multiple solar cell subassemblies monolithically formed on the same substrate. Alternatively, the solar cell subassemblies can be fabricated as separate semiconductor chips that can be coupled together electrically.

In general terms, a solar cell assembly in accordance with one aspect of the present disclosure can include a terminal of first polarity and a terminal of second polarity. The solar cell assembly includes a first semiconductor subassembly including a tandem vertical stack of at least a first upper, a second, third and fourth bottom solar subcells, the first upper subcell having a top contact connected to the terminal of first polarity. A second semiconductor subassembly is disposed adjacent to the first semiconductor subassembly and includes a tandem vertical stock of at least a first upper, a second, third, and fourth bottom solar subcells, the fourth bottom subcell having a bask side contact connected to the terminal of second polarity. The fourth subcell of the first semiconductor subassembly is connected in a series electrical circuit with the third subcell of the second semiconductor subassembly. Thus, a five-junction solar assembly is assembled from two four-junction solar cell subassemblies.

In some cases, the foregoing solar cell assembly can provide increased photoconversion efficiency in a multijunction solar cell for outer space or other applications over the operational life of the photovoltaic power system.

One aspect of the present disclosure relates to the use of aluminum in the active layers of the upper subcells in a multijunction solar cell. The effects of increasing amounts of aluminum as a constituent element in an active layer of a subcell affects the photovoltaic device performance. One measure of the "quality" or "goodness" of a solar cell subcell or junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. There is a theoretical limit to this difference, known as the Shockley-Queisser limit. That is the best that a solar cell junction can be under a given concentration of light at a given temperature.

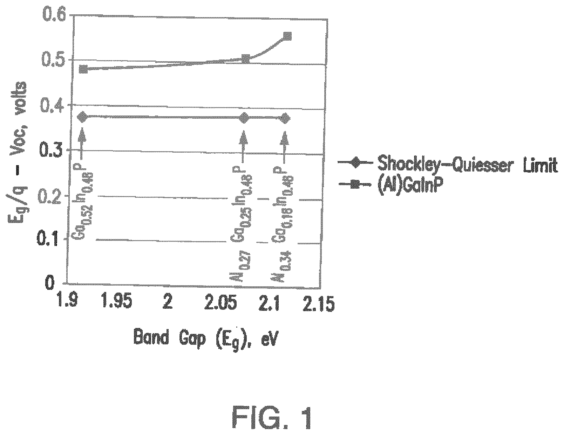

The experimental data obtained for single junction (Al)GaInP solar cells indicates that increasing the A1 content of the junction leads to a larger V_{oc} - E_{g}/q difference, indicating that the material quality of the junction decreases with increasing A1 content. Figure 1 shows this effect. The three compositions cited in the Figure are all lattice matched to GaAs, but have differing A1 composition. As seen by the different compositions represented, with increasing amount of aluminum represented by the x-axis, adding more A1 to the semiconductor composition increases the band gap of the junction, but in so doing also increases V_{oc} - E_{g}/q. Hence, we draw the conclusion that adding A1 to a semiconductor material degrades that material such that a solar cell device made out of that material does not perform relatively as well as a junction with less A1.

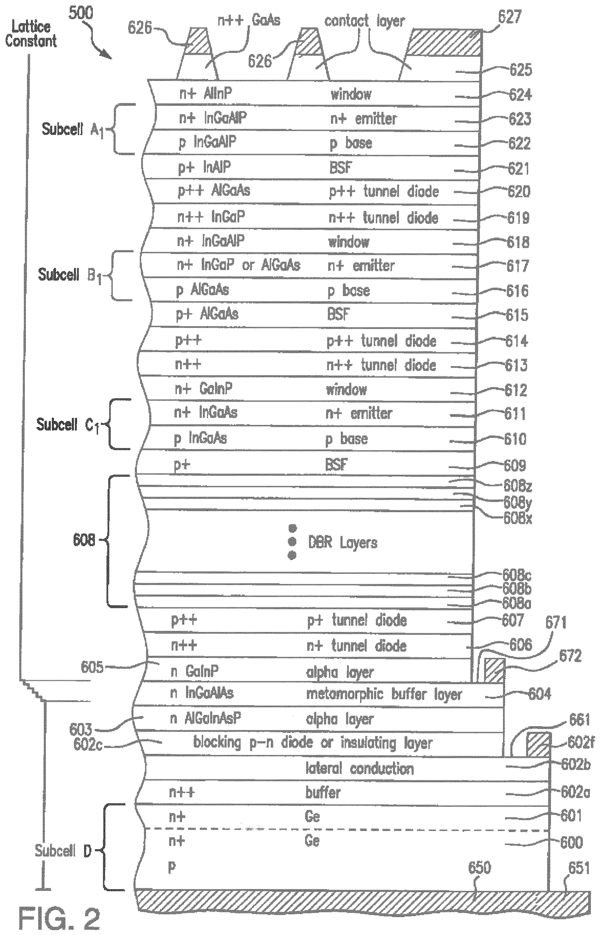

Turning to the fabrication of the multijunction solar cell assembly of the present disclosure, and in particular a five-junction solar cell assembly, FIG. 2 is a cross-sectional view of a first embodiment of a four junction solar cell subassembly 500 after several stages of fabrication including the growth of certain semiconductor layers on the growth substrate, and formation of grids and contacts on the contact layer of the semiconductor body.

As shown in the illustrated example of FIG. 2, the bottom subcell D₁ includes a substrate 600 formed of p-type germanium ("Ge") in some embodiments, which also serves as a base layer. A back metal contact pad 650 formed on the bottom of base layer 600 provides electrical contact to the multijunction solar cell subassembly 500.

In some embodiments, the bottom subcell D₁ is germanium.

The bottom subcell D₁, further includes, for example, a highly doped n-type Ge emitter layer 601, and an n-type indium gallium arsenide ("InGaAs") nucleation layer 602a. The nucleation layer 602a is deposited over the base layer, and the emitter layer 601 is formed in the substrate by diffusion of deposits into the Ge substrate, thereby forming the n-type Ge layer 601.

In the first solar cell subassembly 500 of FIG. 2, a highly doped lateral conduction layer 602b is deposited over layer 601, and a blocking p-n diode or insulating layer 602c is deposited over the layer 602b.

In the embodiment of FIG. 2 of the present disclosure, an alpha layer 603, preferably composed of n-type AlGaInAsP, is deposited over the lateral conduction layer 602d, to a thickness of between 0.25 and 1.0 micron. Such an alpha layer is intended to prevent threading dislocations from propagating, either opposite to the direction of growth into the bottom subcell D₁, or in the direction of growth into the subcell C₁, and is more particularly described in U.S. Patent Application Pub. No. 2009/0078309 A1 (Cornfeld et al.).

A metamorphic layer (or graded interlayer) 604 is deposited over the alpha layer 603 using a surfactant. Layer 604 is preferably a compositionally step-graded series of InGaAlAs layers, preferably with monotonically changing lattice constant, so as to achieve a gradual transition in lattice constant in the semiconductor structure from subcell D₁ to subcell C₁ while minimizing threading dislocations from occurring. In some embodiments, the band gap of layer 606 is not constant throughout its thickness, each sublayer having a band gap in the range equal to equal to 1.22 to 1.34 eV, and otherwise consistent with a value slightly greater than the band gap of the middle subcell C₁. One embodiment of the graded interlayer may also be expressed as being composed of InₓGa₁₋ₓAs, with x and y selected such that the band gap of the interlayer is approximately 1.22 to 1.34 eV or other appropriate band gap.

In the surfactant assisted growth of the metamorphic layer 604, a suitable chemical element is introduced into the reactor during the growth of layer 604 to improve the surface characteristics of the layer. In the preferred embodiment, such element may be a dopant or donor atom such as selenium (Se) or tellurium (Te). Small amounts of Se or Te are therefore incorporated in the metamorphic layer 604, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 606.

In one embodiment of the present disclosure, the layer 604 is composed of a plurality of layers of InGaAs, with monotonically changing lattice constant, each layer having a band gap, approximately in the range of 1.22 to 1.34 eV. In some embodiments, the band gaps are in the range of 1.27 to 1.31 eV. In some embodiments, the band gaps are in the range of 1.28 to 1.29 eV.

The advantage of utilizing a constant bandgap material such as InGaAs is that arsenide-based semiconductor material is much easier to process in standard commercial MOCVD reactors.

Although the preferred embodiment of the present disclosure utilizes a plurality of layers of InGaAs for the metamorphic layer 604 for reasons of manufacturability and radiation transparency, other embodiments of the present disclosure may utilize different material systems to achieve a change in lattice constant from subcell C₁ to subcell D₁. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the second solar cell and less than or equal to that of the fourth solar cell, and having a bandgap energy greater than that of the second solar cell.

An alpha layer 605, preferably composed of n+ type GaInP, is deposited over metamorphic buffer layer 604, to a thickness of about 1.0 micron. Such an alpha layer is intended to prevent threading dislocations from propagating, either opposite to the direction of growth into the subcell D₁, or in the direction of growth into the subcell C₁, and is more particularly described in U.S. Patent Application Pub. No. 2009/0078309 A1 (Cornfeld et al.).

Heavily doped p-type aluminum gallium arsenide ("AlGaAs") and heavily doped n-type gallium arsenide ("GaAs") tunneling junction layers 606, 607 may be deposited over the alpha layer 605 to provide a low resistance pathway between the bottom and middle subcells D₁ and C₁.

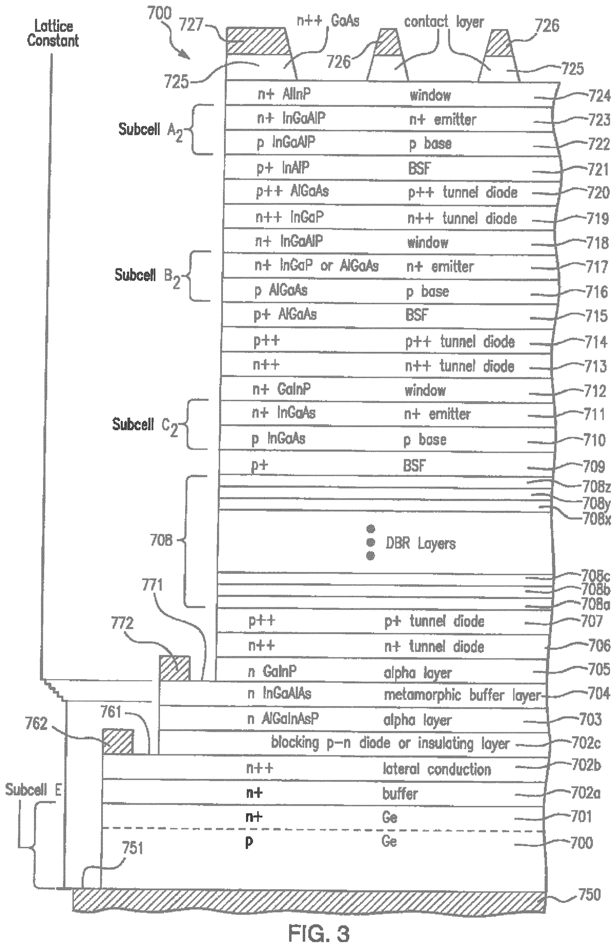

Distributed Bragg reflector (DBR) layers 608 are then grown adjacent to and between the alpha layer 605 and the second solar subcell C₁. The DBR layers 608 are arranged so that light can enter and pass through the second solar subcell C₁ and at least a portion of which can be reflected back into the second solar subcell C₁ by the DBR layers 608. In the embodiment depicted in FIG. 3, the distributed Bragg reflector (DBR) layers 608 are specifically located between the second solar subcell and tunnel diode layer 607; in other embodiments, the distributed Bragg reflector (DBR) layers may be located between alpha layer 605 and tunnel diode layers 606/607.

For some embodiments, distributed Bragg reflector (DBR) layers 608 can be composed of a plurality of alternating layers 608a through 608z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 608a through 608z includes a first DBR layer composed of a plurality of p type AlₓGa₁₋ₓ(In)As layers, and a second DBR layer disposed over the first DBR layer and composed of a plurality of p type Al_{y}Ga_{1-y}(In)As layers, where y is greater than x.

On top of the DBR layers 608 subcell C₁ is grown.

In the illustrated example of FIG. 2, the subcell C₁ includes a highly doped p-type indium aluminum gallium arsenide ("InAlGaAs") back surface field ("BSF") layer 609, a p-type InGaAs base layer 610, a highly doped n-type indium gallium arsenide ("InGaAs") emitter layer 611 and a highly doped n-type indium aluminum phosphide ("AlInP2") window layer 612. The InGaAs base layer 610 of the subcell C₁ can include, for example, approximately 1.5% In. Other compositions may be used as well. The base layer 610 is formed over the BSF layer 609 after the BSF layer is deposited over the DBR layers 608a through 608z.

The window layer 612 is deposited on the emitter layer 611 of the subcell C₁. The window layer 612 in the subcell C₁ also helps reduce the recombination loss and improves passivation of the cell surface of the underlying junctions. Before depositing the layers of the subcell B, heavily doped n-type InGaP and p-type AlGaAs (or other suitable compositions) tunneling junction layers 613, 614 may be deposited over the subcell C₁.

The middle subcell B₁ includes a highly doped p-type indium aluminum gallium arsenide ("InAlGaAs") back surface field ("BSF") layer 615, a p-type AlGaAs base layer 616, a highly doped n-type indium gallium phosphide ("InGaP2") or InAlGaAs layer 617 and a highly doped n-type indium gallium aluminum phosphide ("AlGaAlP") window layer 618. The InGaP emitter layer 617 of the subcell B₁ can include, for example, approximately 50% In. Other compositions may be used as well.

Before depositing the layers of the top cell A₁, heavily doped n-type InGaP and p-type (In)AlGaAs tunneling junction layers 619, 620 may be deposited over the subcell B.

In the illustrated example, the top subcell A₁ includes a highly doped p-type indium aluminum phosphide ("InAlP") BSF layer 621, a p-type InGaAlP base layer 622, a highly doped n-type InGaAlP emitter layer 623 and a highly doped n-type InAlP2 window layer 624. The base layer 623 of the top subcell A is deposited over the BSF layer 621 after the BSF layer 621 is formed over the tunneling junction layers 619, 620 of the subcell B₁. The window layer 624 is deposited over the emitter layer 623 of the top subcell A₁ after the emitter layer 623 is formed over the base layer 622.

A cap or contact layer 625 may be deposited and patterned into separate contact regions over the window layer 624 of the top subcell A₁. The cap or contact layer 625 serves as an electrical contact from the top subcell A₁ to metal grid layer 626. The doped cap or contact layer 625 can be a semiconductor layer such as, for example, a GaAs or InGaAs layer.

After the cap or contact layer 625 is deposited, the grid lines 626 are formed via evaporation and lithographically patterned and deposited over the cap or contact layer 625.

A contact pad 627 which is electrically connected to the grid line 626 is formed on one edge of the subassembly 500 to allow an electrical interconnection to be made to an adjacent subassembly.

Following deposition of the semiconductor layers, the semiconductor body 500 is etched so that several ledges or platforms are formed on intermediate layers so that electrical contact may be made thereto, in particular, in one embodiment, ledges 651 (which may be a portion of the back contact layer 650), 661, and 671.

To this end, the solar cell subassembly can include a plurality of openings in the first semiconductor body, each of the openings extending from a top surface of the first semiconductor body to a different respective contact layer (651, 661, 671) in the first semiconductor body. Such "openings" may include recesses, cavities, holes, gaps, cut-outs, or similar structures, but for simplicity we will subsequently just use the term "opening" throughout this disclosure. In other implementations, we can etch through the rear of the substrate and have all the openings come from the back side. This approach is more efficient as it does not shadow the top two or top three solar subcells, but it results in a solar epitaxial structure of only a few 10s of microns in thickness.

A metal contact pad 672 is deposited on the surface of the ledge 671 which exposes a portion of the top surface of the metamorphic layer 604. This pad 672 allows electrical contact to be made to the bottom of the stack of subcells A₁ through C₁.

A metal contact pad 602f is deposited on the surface of the ledge of 661 which exposes a portion of the top surface of the lateral conduction layer 602b. This pad 602f allows electrical contact to be made to the top or n - terminal of the subcell D.

A metal contact 651 is further provided as part of the back metal layer 650 which allows electrical contact to be made to the p-terminal of subcell D.

FIG. 3 illustrates a second solar cell subassembly 700, which is similar to the solar cell subassembly 500 of FIG. 2 in that it has substantially the same sequence of semiconductor layers with the same compositions and band gaps as the corresponding layers in the first solar cell subassembly 500. Thus, the solar cell subassembly 700 also includes multiple subcells in a tandem stack. In the illustrated example of FIG. 3, the second solar cell subassembly 700 includes an upper first subcell (Subcell A₂), a second and third solar subcells (Subcell C₂ and B₂) disposed adjacent to and lattice matched to the upper first subcell A₂, and a bottom subcell (Subcell E) lattice mismatched to the second subcell C₂.

As with the first solar cell subassembly 500, the subcells A₂, B₂, C₂ of the second solar cell subassembly can be configured so that the short circuit current densities of the three subcells A₂, B₂, C₂ have a substantially equal predetermined first value (J1 = J2 = J3), and the short circuit current density (J4) of the bottom subcell E is at least twice that of the predetermined first value.

Since the semiconductor layers 700 through 725 in subassembly 700 are substantially identical to layers 600 through 625 in subassembly 500, a detailed description of them will not be provided here for brevity.

In order to provide access to the various layers in the second solar cell subassembly 700, various ones of the layers can be exposed partially. Thus, as shown in the example of FIG. 3, various surfaces are partially exposed on the left side of the subassembly 700, for example, using standard photolithographic etching techniques to etch from the top surface of the semiconductor body 700 to the particular contact layer 771, 761 and 751 of interest.

A metal contact pad 772 is deposited on the surface of the ledge of 771 which exposes a portion of the top surface of the metamorphic layer 704. This pad 772 allows electrical contact to be made to the bottom of the stack of subcells A₂ through C₂.

A metal contact pad 762 is deposited on the surface of the ledge of 761 which exposes a portion of the top surface of the lateral conduction layer 702b. This pad 762 allows electrical contact to be made to the top or n - terminal of the subcell E.

A metal contact 751 is further provided as part of the back metal layer 750 which allows electrical contact to be made to the p-terminal of subcell E.

A second embodiment of the second solar cell subassembly (not illustrated) similar to that of FIG. 3 is another configuration with that the metamorphic buffer layer 604 is disposed above the tunnel diode layers 706, 707 and below the DBR layers 708 (not illustrated).

The foregoing multijunction solar cell subassemblies 500, 600, or 700 can be fabricated, for example, in wafer-level processes and then diced into individual semiconductor chips. The various semiconductor layers can be grown, one atop another, using known growth techniques (e.g., MOCVD) as discussed above.

Each solar cell subassembly 500, 600, 700 also can include grid lines, interconnecting bus lines, and contact pads. The geometry and number of the grid lines, bus lines and/or contacts may vary in other implementations.

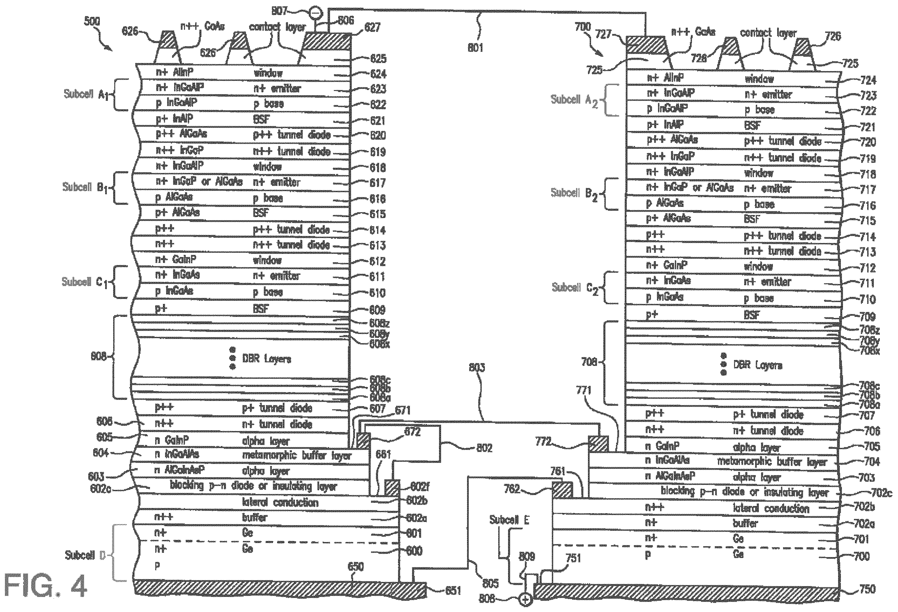

As previously mentioned, two (or more) solar cell subasemblies (e.g., 500 and 700) can be connected together electrically. For example, as shown in FIG. 4, conductive (e.g., metal) interconnections 801, 802, 803, and 805 can be made between different layers of the solar cell subassemblies 500, 700. Some of the interconnections are made between different layers of a single one of the solar cell subassemblies, whereas others of the interconnections are made between the two different solar cell subassemblies. Thus, for example, the interconnection 801 electrically connects together the metal contacts 627 and 727 of the first and second solar cell subassemblies 500 and 700 respectively. In particular, interconnection 803 connects together a contact 672 on the metamorphic layer 604 of the first solar cell subassembly 500 to a contact 772 on the metamorphic layer 704 of the second solar cell subassembly 700. Similarly, the interconnection 805 connects together a contact 651 on the back metal layer 650 of the first solar cell subassembly 500 to a contact 762 on the lateral conduction layer 702b of the second solar cell subassembly 700. Likewise, the interconnection 802 connects together a contact 672 on the metamorphic layer 604 of the first solar cell subassembly 500 to a contact 602f on the lateral conduction layer 602b of the first solar cell subassembly 500.

In some instances, multiple electrically conductive (e.g., metal) contacts can be provided for each of the respective contacts of the solar cell subassemblies 500, 700. This allows each of the interconnections 801 - 804 to be implemented by multiple interconnections between the solar cell subassembly layers rather than just a single interconnection.

As noted above, the solar cell assembly includes a first electrical contact of a first polarity and a second electrical contact of a second polarity. In some embodiments, the first electrical contact 807 is connected to the metal contact 627 on the first solar cell subassembly 500 by an interconnection 806, and the second electrical contact 808 is connected to the back metal contact 751 of the second solar cell subassembly 700 by an interconnection 809.

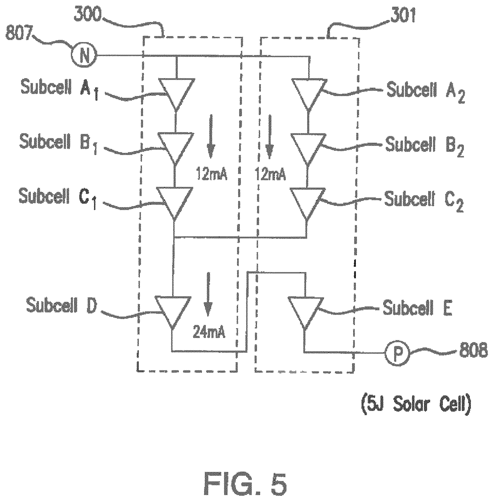

As illustrated in FIG. 5, two or more solar cell subassemblies can be connected electrically as described above to obtain a multijunction (e.g. a four-, five- or six-junction) solar cell assembly. In FIG. 5, the top side (n-polarity) conductivity contact 807 and bottom side (p-polarity) conductive contact 808 for the solar cell assembly are schematically depicted respectively, at the left and right-hand sides of the assembly.

In the example of FIG. 5, one solar cell subassembly 500 includes an upper subcell A₁, two middle subcells B₁, C₁ and a bottom subcell D. The other solar cell subassembly 700 includes an upper subcell A₂, two middle subcells B₂, C₂ and a bottom subcell E. In some implementations, each solar cell subassembly 500, 700 has band gaps in the range of 2.0 to 2.20 eV (or higher) for the top subcell, and (i) 1.65 to 1.8, and (ii) 1.41 eV for the middle subcells, and 0.6 to 0.8 eV, for the bottom subcell, respectively, Further, in some embodiments, the average band gap of all four subcells (i.e., the sum of the four band gaps of each subcell divided by four) in a given solar cell subassembly 500 or 700 is greater than 1.44 eV. Other band gap ranges may be appropriate for some implementations.

In some instances, the fourth (i.e., bottom) subcell is composed of germanium. The indirect band gap of the germanium at room temperature is about 0.66 eV, while the direct band gap of germanium at room temperature is 0.8 eV. Those skilled in the art with normally refer to the "band gap" of germanium as 0.66 eV, since it is lower than the direct band gap value of 0.8 eV.

In some implementations of a five-junction solar cell assembly, such as in the example of FIG. 5, the short circuit density (J_{sc}) of the upper first subcells (A₁, and A₂) and the middle subcells (B₁, B₂, C₁, C₂) is about 12 mA/cm², and the short circuit current density (J_{sc}) of the bottom subcells (D and E) is about 24 mA/cm². Other implementations may have different values.

The present disclosure, like related U.S. Patent Application Serial No. 14/828,206, provides a multijunction solar cell that follows a design rule that one should incorporate as many high band gap subcells as possible to achieve the goal to increase the efficiency at either low temperature, room temperature (28° C), or high temperature (50 to 70° C) EOL. For example, high band gap subcells may retain a greater percentage of cell voltage as temperature increases, thereby offering lower power loss as temperature increases. As a result, both HT-BOL and HT-EOL performance of the exemplary multijunction solar cell, according to the present disclosure, may be expected to be greater than traditional cells.

In view of different satellite and space vehicle requirements in terms of temperature, radiation exposure, and operational life, a range of subcell designs using the design principles of the present disclosure may be provided satisfying typical customer and mission requirements, and several embodiments are set forth hereunder, along with the computation of their efficiency at the end-of-life. The radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As an example, a low earth orbit (LEO) satellite will typically experience radiation equivalent to 5 x 10¹⁴ e/cm² over a five year lifetime. A geosynchronous earth orbit (GEO) satellite will typically experience radiation in the range of 5 x 10¹⁴ e/cm² to 1 x 10 e/cm² over a fifteen year lifetime.

As a baseline for comparison, the cell efficiency (%) measured at room temperature (RT) 28° C and high temperature (HT) 70° C, at beginning of life (BOL) and end of life (EOL), for a standard three junction commercial solar cell (e.g. a SolAero Technologies Corp. Model ZTJ), such as depicted in FIG. 2 of U.S. Patent Application Serial No. 14/828,206, is as follows:

| Condition | Efficiency | |
|---|---|---|
| BOL 28° C | 29.1% | |
| BOL 70° C | 26.4% | |
| | | |
| EOL 70° C | 23.4% | After 5E14 e/cm² radiation |
| EOL 70°C | 22.0% | After 1E15 e/cm² radiation |

For the 5J solar cell assembly described in the present disclosure, the corresponding data is as follows:

| Condition | Efficiency | |
|---|---|---|
| BOL 28° C | 30.6% | |
| BOL 70° C | 27.8% | |
| EOL 70° C | 26.6 % | After 5E14 e/cm² radiation |
| EOL 70° C | 26.1% | After 1E15 e/cm² radiation |

The new solar cell described in the present disclosure has a slightly higher cell efficiency than the standard commercial solar cell (ZTJ) at BOL at 70° C. However, the solar cell described in the present disclosure exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. In short, increased BOL E_{g}/q - V_{oc} may be the most problematic shortcoming of aluminum containing subcells; the other limitations can be mitigated by modifying the doping schedule or thinning base thicknesses.

Although described embodiments of the present disclosure utilizes a vertical tandem stack of four subcells, various aspects and features of the present disclosure can apply to tandem stacks with fewer or greater number of subcells, i.e. two junction cells, three junction cells, five junction cells, etc.

## Claims

1. A multijunction solar cell assembly including a terminal of first polarity (807) and a terminal of second polarity (808) comprising:
a first semiconductor body (500) including a tandem vertical stack of at least a first upper solar subcell (A1), a second solar subcell (C1), a third solar subcell (B1), and a bottom solar subcell (D), the first upper
subcell (A1) having a top contact (627) connected to the terminal of first polarity (807), and the bottom solar subcell (D) having a top contact (602f) and a bottom contact (650);
a second semiconductor body (700) disposed adjacent to the first semiconductor body (500) and including a tandem vertical stack of at least a first upper (A2), a second (C2) a third (B2) and a bottom (E) solar subcells, the first upper subcell (A2) of the second semiconductor body (700) having a top contact (727) connected to the terminal of first polarity (807), and the bottom subcell (E) of the second semiconductor body (700) having a top contact (762) and a bottom contact (750) with its bottom contact (750) connected to the terminal of second polarity (808);
the short circuit current density of each bottom subcell (D, E) being at least twice that of the solar subcells in each parallel stack which are connected in a series with the bottom subcell (D, E);
wherein the first (500) and second (700) semiconductor body each comprises a first highly doped lateral conduction layer (604, 704) electrically connected (803) to each other and disposed adjacent to and beneath the second solar subcell (C1, C2) of each respective body (500, 700);
and wherein the first (500) and second (700) semiconductor body each comprises a blocking p-n diode or insulating layer (602c, 702c) disposed adjacent to and beneath the first highly doped lateral conduction layer (604, 704); and a second highly doped lateral conduction layer (602b, 702b) disposed adjacent to and beneath the respective blocking p-n diode or insulating layer (602c, 702c),
an electrical connection (802, 803) between the first lateral conduction layer (604, 704) of the first (500) and the second (700) semiconductor body and the second lateral conduction layer (602b) of the first semiconductor body;
the bottom solar subcell (D, E) of each respective body (500, 700) being disposed adjacent to and beneath the second highly doped lateral conduction layer (602b, 702b), with the bottom subcell (D) of the first semiconductor body (500) being connected in a series electrical circuit with the bottom subcell (E) of the second semiconductor body (700) so that at least a five junction solar cell is formed by the assembly,
and wherein the first lateral conduction layer (604, 704) in each of the first (500) and second (700) semiconductor bodies is compositionally graded to substantially lattice match the second solar subcell on one side and the bottom solar subcell on the other side, and is composed of any of the As, P, N, Sb based III - V compound semiconductors subject to the constraints of having the in-plane lattice parameter less than or equal to that of the second solar subcell and greater than or equal to that of the bottom solar cell; wherein the first and second semiconductor bodies (500, 700) include the tandem vertical stack of at least the first upper (A1, A2), the second (C1, C2) and third (B1, B2) solar subcells, and the first (D) and second (E) bottom subcells, so that at least the five junction solar cell is formed by the assembly, with the first upper (A1, A2), the second (C1, C2) and third (B1, B2) solar subcells being current matched, and the first (D) and second (E) bottom subcells being current mismatched from the first upper (A1, A2), the second (C1, C2) and third (B1, B2) solar subcells, wherein the bottom subcell (D, E) of the first (500) and second (700) semiconductor bodies has a band gap in the range of approximately 0.67 eV, the second subcell (C1, C2) of the first (500) and second (700) semiconductor bodies has a band gap in the range of approximately 1.41 eV to 1.31 eV, the third subcell (B1, B2) of the first (500) and second (700) semiconductor bodies has a band gap in the range of approximately 1.65 to 1.8 eV and the upper first subcell (A1, A2) of the first (500) and second (700) semiconductor bodies has a band gap in the range of 2.0 to 2.20 eV.

2. A multijunction solar cell assembly as defined in claim 1, further comprising:
a first electrical contact on the first lateral conduction layer, and a second electrical contact on the second lateral conduction layer, and wherein the electrical connection is a wire welded to the first electrical contact at one end, and the second electrical contact at the other end; and
an electrical connection between the bottom contact of the first bottom subcell, and the top contact of the second bottom subcell.

3. A multijunction solar cell assembly as defined in claim 1, wherein the first lateral conduction layer in each semiconductor body (500, 700) is composed of InₓAl_{y}Ga_{1-x-y}As or InₓGa₁₋ₓP with 0 < x < 1, 0 < y < 1, and x and y selected such that the band gap is in the range of 1.41 eV to 1.6 eV and may vary throughout its thickness, and is compositionally graded to substantially lattice match the second solar subcell (C1, C2) on one side and the bottom solar subcell (D, E) on the other side.

4. The multijunction solar cell assembly multijunction solar cell as defined in claim 1, wherein:
the upper first subcell (A1, A2) is composed of indium gallium aluminum phosphide (InGaAlP);
the third solar subcell (B1, B2) includes an emitter layer composed of indium gallium phosphide (InGaP), indium aluminum gallium arsenide (InAlGaAs) or indium gallium arsenide phosphide (InGaAsP), and a base layer composed of indium aluminum gallium arsenide or indium gallium arsenide phosphide (InGaAsP);
the second solar subcell (C1, C2) is composed of indium gallium arsenide;
the fourth subcell is composed of germanium; and
the lateral conduction layer is composed of InₓAl_{y}Ga_{1-x-y}As or InₓGa₁₋ₓP with 0 < x < 1, 0 < y < 1, and x and y selected such that the band gap is in the range of 1.41 eV to 1.6 eV and may vary throughout its thickness.

5. The multijunction solar cell assembly as defined in claim 1, wherein the upper first subcell (A1, A2) has a band gap in the range of 2.0 to 2.20 eV and is composed of indium gallium aluminum phosphide (InGaAlP); the third solar subcell (B1, B2) has a band gap in the range of approximately 1.65 to 1.8 eV and includes an emitter layer composed of indium gallium phosphide (InGaP), indium aluminum gallium arsenide (InAlGaAs) or indium gallium arsenide phosphide (InGaAsP), and a base layer composed of indium aluminum gallium arsenide or indium gallium arsenide phosphide (InGaAsP) ; the second solar subcell (C1, C2) has a band gap in the range of approximately 1.3 to 1.41 eV and is composed of indium gallium arsenide; and
the fourth subcell is composed of germanium; the upper first subcell is composed of indium gallium aluminum phosphide.

6. A multijunction solar cell assembly as defined in claim 1, further comprising:
a first distributed Bragg reflector (DBR) layer disposed above the bottom solar subcell and arranged so that light can enter and pass through the solar subcell disposed above the bottom subcell and at least a portion of which can be reflected back into the solar subcell located above the bottom subcell by the DBR layer, and the distributed Bragg reflector layer is composed of a plurality of alternating layers of lattice matched materials with discontinuities in their respective indices of refraction, wherein the difference in refractive indices between alternating layers is maximized in order to minimize the number of periods required to achieve a given reflectivity, and the thickness and refractive index of each period determines the stop band and its limiting wavelength, and the DBR layer includes a first DBR layer composed of a plurality of p type AlₓGa₁₋ₓ(In)As layers, and a second DBR layer disposed over the first DBR layer and composed of a plurality of n or p type Al_{y}Ga_{1-y}(In)As layers, where 0 < x < 1, 0 < y < 1, and y is greater than x, and the term (In) denotes an optional inclusion of up to 10% indium.

7. A multijunction solar cell as defined in claim 6, further comprising:
a second distributed Bragg reflector (DBR) layer adjacent to and between the third and the fourth solar subcells (D, E) and arranged so that light can enter and pass through the third solar subcell (B1, B2) and at least a portion of which can be reflected back into the third solar subcell (B1, B2) by the DBR layer, and the distributed Bragg reflector layer is composed of a plurality of alternating layers of lattice matched materials with discontinuities in their respective indices of refraction.

8. A multijunction solar cell assembly as defined in claim 1, wherein the first and second semiconductor bodies (500, 700) come from a single semiconductor body that has been singulated to form to spatially separated bodies.

9. A multijunction solar cell as defined in claim 1, wherein the average band gap of all four subcells in each of the semiconductor bodies (i.e., the sum of the four lowest direct or indirect band gaps of the materials of each subcell in the semiconductor body divided by 4) is greater than 1.44 eV.

10. A multijunction solar cell assembly as defined in claim 1, further comprising a first alpha layer deposited over the first lateral conduction layer to a thickness of between 0.25 and 1.0 micron to prevent threading dislocations from propagating, either opposite to the direction of growth or in the direction of growth into the second subcell and further comprising a second alpha layer deposited over the blocking p-n diode or insulating layer to a thickness of between 0.25 and 1.0 micron to prevent threading dislocations from propagating, either opposite to the direction of growth or in the direction of growth into the second subcell, further comprising a tunnel diode disposed over the first lateral conduction layer and below the distributed Bragg reflector (DBR) layer.

11. A method of forming a solar cell module including a terminal of first polarity and a terminal of second polarity comprising:
forming a first semiconductor body (500) including a tandem vertical stack of at least a first upper (A1), a second (C1), third (B1), which are current matched, and fourth solar subcells (D), the first upper subcell (A1) having a top contact connected to the terminal of first polarity and the bottom fourth solar subcell (D) being current mismatched from the first (A1), second (C1) and third (B1) solar subcells;
forming a second semiconductor body (700) including a tandem vertical stack of at least a first upper (A2), second (C2) and third (B2) subcells, and a bottom fourth solar subcell (E) that is current mismatched from the first (A2), second (C2) and third (B2) solar subcells;
the short circuit current density of the bottom subcell (D, E) being at least twice that of the solar subcells (A1, A2, B1, B2, C1, C2) in each parallel stack which are connected in a series with the bottom subcell (D, E);
disposing the first semiconductor body (500) adjacent to the second semiconductor body (700) and connecting the top contact of the first upper subcells (A1, A2) of the first and second semiconductor bodies (500, 700); and
connecting the fourth subcell (D) of the first semiconductor body (500) in a series electrical circuit with the fourth subcell (E) of the second semiconductor body (700),
wherein the first (500) and second (700) semiconductor body each comprises a first highly doped lateral conduction layer (604, 704) electrically connected to each other and disposed adjacent to and beneath the second solar subcell (C1, C2) of each respective body,
and wherein the first and second semiconductor body (500, 700) each comprises a blocking p-n diode or insulating layer (602c, 702c) disposed adjacent to and beneath the first highly doped lateral conduction layer (604, 704); and a second highly doped lateral conduction layer (602b, 702b) disposed adjacent to and beneath the respective blocking p-n diode or insulating layer (604, 704),
an electrical connection (802, 803) between the first lateral conduction layer (704) of the second semiconductor body (700) and the second lateral conduction layer (602b) of the first semiconductor body (500);
the bottom solar subcell (D, E) of each respective body (500, 700) being disposed adjacent to and beneath the second highly doped lateral conduction layer (602b, 702b), with the bottom subcell (D) of the first semiconductor body (500) being connected in a series electrical circuit (805) with the bottom subcell (E) of the second semiconductor body (700) so that at least a four junction solar cell is formed by the assembly,
and wherein the first lateral conduction layer (604, 704) in each of the first and second semiconductor bodies (500, 700) is compositionally graded to substantially lattice match the second solar subcell on one side and the bottom solar subcell on the other side, and is composed of any of the As, P, N, Sb based III - V compound semiconductors subject to the constraints of having the in-plane lattice parameter less than or equal to that of the second solar subcell and greater than or equal to that of the bottom solar cell; wherein the first upper (A1, A2), the second (C1, C2) and third solar (B1, B2) subcells being current matched, and the bottom subcells (D, E) being current mismatched from the first upper (A1, A2), the second (C1, C2), and the third (B1, B2) solar subcells, wherein the bottom subcell (D, E) of the first and second semiconductor bodies (500, 700) has a band gap in the range of approximately 0.67 eV, the second subcell (C1, C2) of the first and second semiconductor bodies (500, 700) has a band gap in the range of approximately 1.41 eV to 1.31 eV, the third subcell (B1, B2) of the first and second semiconductor bodies (500, 700) has a band gap in the range of approximately 1.65 to 1.8 eV and the upper first subcell (A1, A2) of the first and second semiconductor bodies (500, 700) has a band gap in the range of 2.0 to 2.20 eV.

## Patentansprüche

1. Mehrfachsolarzellen-Baugruppe mit einer Klemme einer ersten Polarität (807) und einer Klemme einer zweiten Polarität (808), aufweisend:
einen ersten Halbleiterkörper (500), einschließend einen vertikalen Tandemstapel aus mindestens einer ersten oberen Solarteilzelle (A1), einer zweiten Solarteilzelle (C1) und einer dritten Solarzelle (B1) und einer unteren Solarteilzelle (D), wobei die erste obere Teilzelle (A1) einen oberen Kontakt (627) aufweist, der mit der Klemme der ersten Polarität (807) verbunden ist und wobei die untere Solarteilzelle (D) einen oberen Kontakt (602f) und einen unteren Kontakt (650) aufweist;
einen zweiten Halbleiterkörper (700), der angrenzend zu dem ersten Halbleiterkörper (500) angeordnet ist und einen vertikalen Tandemstapel aus mindestens einer ersten oberen (A2), einer zweiten (C2), einer dritten (B2) und einer unteren (E) Solarteilzelle einschließt, wobei die erste obere Teilzelle (A2) des zweiten Halbleiterkörpers (700) einen oberen Kontakt (727) aufweist, der mit der Klemme der ersten Polarität (807) verbunden ist, und die untere Teilzelle (E) des zweiten Halbleiterkörpers (700) einen oberen Kontakt (762) und einen unteren Kontakt (750) aufweist, wobei ihr unterer Kontakt (750) mit der Klemme der zweiten Polarität (808) verbunden ist;
wobei die Kurzschlussstromdichte von jeder unteren Teilzelle (D, E) mindestens doppelt so groß wie die der Solarteilzellen in jedem parallelen Stapel ist, die in einer Reihe mit der unteren Teilzelle (D, E) verbunden sind;
wobei der erste (500) und der zweite (700) Halbleiterkörper jeweils eine erste hochdotierte laterale Leitungsschicht (604, 704) aufweist, die elektrisch miteinander verbunden (803) sind und die angrenzend zu und unter der zweiten Solarteilzelle (C1, C2) jedes jeweiligen Körpers (500, 700) angeordnet sind;
und wobei der erste (500) und der zweite (700) Halbleiterkörper jeweils eine p-n-Sperrdiode oder Isolierschicht (602c, 702c), die angrenzend zu und unter der ersten hoch dotierten lateralen Leitungsschicht (604, 704) angeordnet ist; und eine zweite hochdotierte laterale Leitungsschicht (602b, 702b) aufweisen, die angrenzend zu und unter der jeweiligen p-n-Sperrdiode oder Isolierschicht (602c, 702c) angeordnet ist,
eine elektrische Verbindung (802, 803) zwischen der ersten lateralen Leitungsschicht (604, 704) des ersten (500) und des zweiten (700) Halbleiterkörpers und der zweiten lateralen Leitungsschicht (602b) des ersten Halbleiterkörpers;
wobei die untere Solarteilzelle (D, E) jedes jeweiligen Körpers (500, 700) angrenzend zu und unter der zweiten hochdotierten lateralen Leitungsschicht (602b, 702b) angeordnet ist, wobei die untere Teilzelle (D) des ersten Halbleiterkörpers (500) in einer elektrischen Reihenschaltung mit der unteren Teilzelle (E) des zweiten Halbleiterkörpers (700) verbunden ist, so dass mindestens eine Fünffachsolarzelle durch die Baugruppe gebildet ist,
und wobei die erste laterale Leitungsschicht (604, 704) in jedem der ersten (500) und zweiten (700) Halbleiterkörper kompositorisch so abgestuft ist, dass sie an die zweite Solarteilzelle auf der einen Seite und der unteren Solarteilzelle auf der anderen Seite im Wesentlichen gitterangepasst ist und sich aus einem As-, P-, N-, Sb-basierten III - V-Verbindungshalbleiter zusammensetzt, mit der Maßgabe, dass sie einen Gitterparameter in der Ebene aufweist, der kleiner oder gleich dem der zweiten Solarteilzelle und größer oder gleich dem der unteren Solarzelle ist;
wobei der erste und zweite Halbleiterkörper (500, 700) den vertikalen Tandemstapel aus der ersten oberen (A1, A2), der zweiten (C1, C2) und dritten (B1, B2) Solarteilzelle und der ersten (D) und zweiten (E) unteren Teilzelle einschließen, so dass mindestens die Fünffachsolarzelle durch die Baugruppe gebildet ist, wobei die ersten oberen (A1, A2), die zweiten (C1, C2) und dritten (B1, B2) Solarteilzellen stromangepasst sind, und die erste (D) und zweite (E) unteren Teilzellen zu der ersten oberen (A1, A2), der zweiten (C1, C2) und dritten (B1, B2) Solarteilzellen stromfehlangepasst sind, wobei die untere Teilzelle (D, E) des ersten (500) und zweiten (700) Halbleiterkörpers eine Bandlücke im Bereich von etwa 0,67 eV aufweist, die zweite Teilzelle (C1, C2) des ersten (500) und zweiten (700) Halbleiterkörpers eine Bandlücke im Bereich von etwa 1,41 eV bis 1,31 eV aufweist, die dritte Teilzelle (B1, B2) des ersten (500) und zweiten (700) Halbleiterkörpers eine Bandlücke im Bereich von etwa 1,65 bis 1,8 eV aufweist und die obere erste Teilzelle (A1, A2) des ersten (500) und zweiten (700) Halbleiterkörpers eine Bandlücke im Bereich von 2,0 bis 2,20 eV aufweist.

2. Mehrfachsolarzellen-Baugruppe gemäß Anspruch 1, ferner aufweisend
einen ersten elektrischen Kontakt auf der ersten lateralen Leitungsschicht und einen zweiten elektrischen Kontakt auf der zweiten lateralen Leitungsschicht, und wobei die elektrische Verbindung ein Draht ist, der mit dem ersten elektrischen Kontakt an einem Ende und dem zweiten elektrischen Kontakt am anderen Ende verschweißt ist; und
eine elektrische Verbindung zwischen dem unteren Kontakt der ersten unteren Teilzelle und dem oberen Kontakt der zweiten unteren Teilzelle.

3. Mehrfachsolarzellen-Baugruppe gemäß Anspruch 1, wobei
die erste laterale Leitungsschicht in jedem Halbleiterkörper (500, 700) aus InₓAl_{y}Ga_{1-x-y}As oder InₓGa₁₋ₓP mit 0< x < 1, 0 < y < 1 zusammengesetzt ist, und x und y ausgewählt sind, so dass die Bandlücke im Bereich von 1,41 eV bis 1,6 eV liegt und durch ihre Dicke hindurch variieren kann und kompositorisch so abgestuft ist, um auf einer Seite zur zweiten Solarteilzelle (C1, C2) und auf der anderen Seite zur unteren Solarteilzelle (D, E) gitterangepasst zu sein.

4. Mehrfachsolarzellen-Baugruppe gemäß Anspruch 1, wobei:
die obere erste Teilzelle (A1, A2) aus Indium-Gallium-Aluminiumphosphid (InGaAlP) zusammengesetzt ist;
die dritte Solarteilzelle (B1, B2) eine Emitterschicht, die aus Indium-Galliumphosphid (InGaP), Indium-Aluminium-Galliumarsenid (InAlGaAs) oder Indium-Galliumarsenidphosphid (InGaAsP) zusammengesetzt ist, und eine Basisschicht einschließt, die aus Indium-Aluminium-Galliumarsenid oder Indium-Galliumarsenid (InGaAsP) zusammengesetzt ist;
die zweite Solarteilzelle (C1, C2) aus Indium-Galliumarsenid zusammengesetzt ist;
die vierte Teilzelle aus Germanium zusammengesetzt ist; und
die laterale Leitungsschicht aus InₓAl_{y}Ga_{1-x-y}As oder InₓGa₁₋ₓP mit 0 < x < 1, 0 < y < 1 zusammengesetzt ist und x und y ausgewählt sind, so dass die Bandlücke im Bereich von 1,41 eV bis 1,6 eV liegt und durch ihre Dicke hindurch variieren kann.

5. Mehrfachsolarzellen-Baugruppe gemäß Anspruch 1, wobei
die obere erste Teilzelle (A1, A2) eine Bandlücke im Bereich von 2,0 bis 2,20 eV aufweist und aus Indium-Gallium-Aluminiumphosphid (InGaAlP) zusammengesetzt ist;
die dritte Solarteilzelle (B1, B2) eine Bandlücke im Bereich von etwa 1,65 bis 1,8 eV aufweist und eine Emitterschicht, die aus Indium-Galliumphosphid (InGaP), Indium-Aluminium-Galliumarsenid (InAlGaAs) oder Indium-Galliumarsenidphosphid (InGaAsP) zusammengesetzt ist, und eine Basisschicht einschließt, die aus Indium-Aluminium-Galliumarsenid oder Indium-Galliumarsenidphosphid (InGaAsP) zusammengesetzt ist;
die zweite Solar-Teilzelle (C1, C2) eine Bandlücke im Bereich von etwa 1,3 bis 1,41 eV aufweist und aus Indium-Galliumarsenid zusammengesetzt ist; und
die vierte Teilzelle aus Germanium zusammengesetzt ist; die obere erste Teilzelle aus Indium-Gallium-Aluminiumphosphid zusammengesetzt ist.

6. Mehrfachsolarzellen-Baugruppe gemäß Anspruch 1, ferner aufweisend:
eine erste Bragg-Spiegel- bzw. Distributed Bragg-Reflektor (DBR)-Schicht, die auf der unteren Solarteilzelle angeordnet und so angeordnet ist, dass Licht in die auf der unteren Teilzelle angeordneten Solarteilzelle eintreten und durchgehen kann und mindestens ein Teil davon in die auf der unteren Teilzelle angeordneten Solarteilzelle durch die DBR-Schicht zurückreflektiert werden kann, und wobei die Bragg-Spiegel-Schicht aus einer Vielzahl von abwechselnden Schichten von gitterangepassten Materialien mit Diskontinuitäten in ihren jeweiligen Brechungsindizes zusammengesetzt ist, wobei der Unterschied in den Brechungsindizes zwischen den abwechselnden Schichten maximiert ist, um die Anzahl der Perioden zu minimieren, die erforderlich sind, um eine bestimmte Reflektivität zu erreichen, und die Dicke und der Brechungsindex jeder Periode das Sperrband und seine begrenzende Wellenlänge bestimmen und die DBR-Schicht eine erste DBR-Schicht, die aus einer Vielzahl von p-Typ AlₓGa₁₋ₓ(In)Al-Schichten zusammengesetzt ist, und eine zweite DBR-Schicht einschließt, die auf der ersten DBR-Schicht angeordnet ist und aus einer Vielzahl von n- oder p-Typ Al_{y}Ga_{1-y}(In)As-Schichten zusammengesetzt ist, wobei 0 < x < 1, 0 < y < 1 und y größer als x ist und der Begriff (In) eine optionale Aufnahme von bis zu 10%Indium bedeutet.

7. Mehrfachsolarzellen-Baugruppe gemäß Anspruch 6, die ferner aufweist:
eine zweite Bragg-Spiegel- bzw. Distributed-Bragg-Reflektor (DBR)-Schicht angrenzend zu und zwischen der dritten und vierten Solarteilzelle (D, E) und so angeordnet, dass Licht in die dritte Solarteilzelle (B1, B2) eintreten und durchtreten kann und mindestens ein Teil davon durch die DBR-Schicht in die dritte Solarteilzelle (B1, B2) zurückreflektiert werden kann, und wobei die Bragg-Spiegel-Schicht aus einer Vielzahl von abwechselnden Schichten von gitterangepassten Materialien mit Diskontinuitäten in ihren jeweiligen Brechungsindizes zusammengesetzt ist.

8. Mehrfachsolarzellen-Baugruppe gemäß Anspruch 1, wobei der erste und zweite Halbleiterkörper (500, 700) aus einem einzigen Halbleiterkörper stammen, der zu räumlich getrennten Körpern vereinzelt worden ist, um beabstandete getrennte Körper zu bilden.

9. Mehrfachsolarzelle gemäß Anspruch 1, wobei die durchschnittliche Bandlücke aller vier Teilzellen in jedem der Halbleiterkörper (d. h. die Summe der vier niedrigsten direkten oder indirekten Bandlücken der Materialien jeder Teilzelle im Halbleiterkörper geteilt durch 4) größer als 1,44 eV ist.

10. Mehrfachsolarzellen-Baugruppe gemäß Anspruch 1, ferner aufweisend eine erste Alphaschicht, die auf der ersten lateralen Leitungsschicht mit einer Dicke zwischen 0,25 und 1,0 Mikron abgeschieden ist, um zu verhindern, dass sich Threadingverlagerungen entweder entgegen der Wachstumsrichtung oder in Wachstumsrichtung in die zweite Teilzelle fortpflanzen, und ferner aufweisend eine zweite Alphaschicht, die auf der p-n-Sperrdiode oder der Isolierschicht mit einer Dicke zwischen 0,25 und 1,0 Mikron abgeschieden ist, zu verhindern, dass sich Threadingverlagerungen entweder entgegen der Wachstumsrichtung oder in Wachstumsrichtung der zweiten Teilzelle fortpflanzen, ferner aufweisend eine Tunneldiode, die auf der ersten lateralen Leitungsschicht und unterhalb der Bragg-Spiegel (DBR)- Schicht angeordnet ist.

11. Verfahren zur Bildung eines Solarzellenmoduls, einschließlich einer Klemme einer ersten Polarität und einer Klemme einer zweiten Polarität, aufweisend:
Bilden eines ersten Halbleiterkörpers (500), einschließlich eines vertikalen Tandemstapels aus mindestens einer ersten oberen (A1), einer zweiten (C1), dritten (B1) Solarteilzelle, die stromabgestimmt sind, und vierte Solarteilzelle (D), wobei die erste obere Teilzelle (A1) einen oberen Kontakt aufweist, der mit der Klemme der ersten Polarität verbunden ist, und wobei die untere vierte Solarteilzelle (D) stromfehlgestimmt zu der ersten (A1), zweiten (C1) und dritten (B1) Solarteilzelle ist;
Bilden eines zweiten Halbleiterkörpers (700), einschließlich eines vertikalen Tandemstapels aus mindestens einer ersten oberen (A2), zweiten (C2) und dritten (B2) Teilzelle und einer unteren vierten Solarteilzelle (E), die stromfehlgestimmt zu der ersten (A2), zweiten (C2) und dritten (B2) Solarteilzelle ist;
wobei die Kurzschlussstromdichte der unteren Teilzelle (D, E) mindestens doppelt so groß ist wie die der Solarteilzellen (A1, A2, B1, B2, C1, C2) in jedem parallelen Stapel, die in einer Reihe mit der unteren Teilzelle (D, E) verbunden sind;
Anordnen des ersten Halbleiterkörpers (500) angrenzend zu dem zweiten Halbleiterkörper (700) und Verbinden des oberen Kontakts der ersten oberen Teilzellen (A1, A2) des ersten und zweiten Halbleiterkörpers (500, 700); und
Verbinden der vierten Teilzelle (D) des ersten Halbleiterkörpers (500) in einer elektrischer Reihenschaltung mit der vierten Teilzelle (E) des zweiten Halbleiterkörpers (700), wobei der erste (500) und der zweite (700) Halbleiterkörper jeweils eine erste hochdotierte laterale Leitungsschicht (604, 704) aufweisen, die elektrisch miteinander verbunden und angrenzend zu und unter der zweiten Solarteilzelle (C1, C2) jedes jeweiligen Körpers angeordnet sind,
und wobei der erste und zweite Halbleiterkörper (500, 700) jeweils eine p-n-Sperrdiode oder Isolierschicht (602c, 702c), die angrenzend zu und unter der ersten hochdotierten lateralen Leitungsschicht (604, 704) angeordnet ist; und eine zweite hochdotierte laterale Leitungsschicht (602b, 702b) aufweisen, die angrenzend zu und unter der jeweiligen p-n-Sperrdiode oder Isolierschicht (604, 704) angeordnet ist,
eine elektrische Verbindung (802, 803) zwischen der ersten lateralen Leitungsschicht (604, 704) des ersten (500) und des zweiten (700) Halbleiterkörpers und der zweiten lateralen Leitungsschicht (602b) des ersten Halbleiterkörpers;
wobei die untere Solarteilzelle (D, E) jedes jeweiligen Körpers (500, 700) angrenzend zu und unter der zweiten hochdotierten lateralen Leitungsschicht (602b, 702b) angeordnet ist, wobei die untere Teilzelle (D) des ersten Halbleiterkörpers (500) in einer elektrischen Reihenschaltung mit der unteren Teilzelle (E) des zweiten Halbleiterkörpers (700) verbunden ist, so dass mindestens eine Vierfachsolarzelle durch die Baugruppe gebildet ist,
und wobei die erste laterale Leitungsschicht (604, 704) in jedem der ersten (500) und zweiten (700) Halbleiterkörper kompositorisch so abgestuft ist, dass sie an die zweite Solarteilzelle auf der einen Seite und der unteren Solarteilzelle auf der anderen Seite im Wesentlichen gitterangepasst ist und aus einem As-, P-, N-, Sb-basierten III - V-Verbindungshalbleiter zusammensetzt ist, mit der Maßgabe, dass sie einen Gitterparameter in der Ebene aufweist, der kleiner oder gleich dem der zweiten Solarteilzelle und größer oder gleich dem der unteren Solarzelle ist;
wobei die ersten oberen (A1, A2), die zweiten (C1, C2) und dritten (B1, B2) Solarteilzellen stromangepasst sind, wobei die unteren Teilzellen (D, E) des ersten und zweiten Halbleiterkörpers (500, 700) eine Bandlücke im Bereich von etwa 0,67 eV aufweisen, die zweite Teilzelle (C1, C2) des ersten und zweiten Halbleiterkörpers (500, 700) eine Bandlücke im Bereich von etwa 1,41 eV bis 1,31 eV aufweist, die dritte Teilzelle (B1, B2) des ersten und zweiten Halbleiterkörpers (500, 700) eine Bandlücke im Bereich von etwa 1,65 bis 1,8 eV aufweist und die obere erste Teilzelle (A1, A2) des ersten und zweiten Halbleiterkörpers (500, 700) eine Bandlücke im Bereich von 2,0 bis 2,20 eV aufweist.

## Revendications

1. Un assemblage de cellules solaires multijonctions contenant un terminal de première polarité (807) et un terminal de deuxième polarité (808) comprenant:
un premier corps semi-conducteur (500) contenant une pile verticale tandem d'au moins une première sous-cellule solaire supérieure (A1), une deuxième sous-cellule solaire (C1), et une troisième sous-cellule solaire (B1) et une sous-cellule solaire inférieure (D), la première sous-cellule supérieure (A1) ayant un contact supérieur (627) relié au terminal de la première polarité (807), et la sous-cellule solaire inférieure (D) ayant un contact supérieur (602f) et un contact inférieur (650);
un deuxième corps semi-conducteur (700) disposé adjacent au premier corps semi-conducteur (500) et comprenant une pile verticale tandem d'au moins une première sous-cellule solaire supérieure (A2), une deuxième sous-cellule solaire (C2), une troisième sous-cellule solaire (B1) et une sous-cellule solaire inférieure (E), la première sous-cellule supérieure (A2) du deuxième corps semi-conducteur (700) ayant un contact supérieur (727) relié au terminal de la première polarité (807), et la sous-cellule inférieure (E) du deuxième corps semi-conducteur (700) ayant un contact supérieur (762) et un contact inférieur (750), dans lequel son contact inférieur (750) est relié au terminal de la deuxième polarité (808);
la densité de courant de court-circuit de chaque sous-cellule inférieure (D, E) étant au moins deux fois plus grande que celle des sous-cellules solaires de chaque pile parallèle qui sont reliées dans une série à la sous-cellule inférieure (D, E);
les premier (500) et deuxième corps semi-conducteur (700) comprenant chacun une première couche de conduction latérale hautement dopée (604, 704) reliée électriquement (803) les unes aux autres et disposée adjacente à et sous la deuxième sous-cellule solaire (C1, C2) de chaque corps respectif (500, 700);
et les premier (500) et le deuxième corps semi-conducteur (700) comprenant chacun une diode p-n de blocage ou une couche isolante (602c, 702c) disposée adjacente à et sous la première couche de conduction latérale hautement dopée (604, 704); et une deuxième couche de conduction latérale hautement dopée (602b, 702b) disposée adjacente à et sous la diode p-n de blocage ou la couche isolante respective (602c, 702c),
une connexion électrique (802, 803) entre la première couche de conduction latérale (604, 704) des premier (500) et deuxième (700) corps semi-conducteur et la deuxième couche de conduction latérale (602b) du premier corps semi-conducteur;
la sous-cellule solaire inférieure (D, E) de chaque corps respectif (500, 700) étant disposée adjacente à et sous la deuxième couche de conduction latérale hautement dopée (602b, 702b), la sous-cellule inférieure (D) du premier corps semi-conducteur (500) étant reliée dans un circuit électrique de série à la sous-cellule inférieure (E) du deuxième corps semi-conducteur (700) de sorte qu'au moins une cellule solaire à cinq jonctions est formée par l'assemblage,
et dans lequel la première couche de conduction latérale (604, 704) dans chacun des premier (500) et deuxième (700) corps semi-conducteurs est graduée en composition pour être adaptée en réseau sensiblement à la deuxième sous-cellule solaire d'un côté et à la sous-cellule solaire inférieure de l'autre côté, et est composée de l'un des semi-conducteurs de composés III - V à base d'As, P, N, Sb, soumis aux contraintes d'avoir le paramètre de réseau en plan inférieur ou égal à celui de la deuxième sous-cellule solaire et supérieur ou égal à celui de la cellule solaire inférieure;
dans lequel les premier et deuxième corps semi-conducteurs (500, 700) comprennent une pile verticale tandem d'au moins une première sous-cellule solaire supérieure (A1, A2), la deuxième sous-cellule solaire (C1, C2) et la troisième sous-cellule solaire (B1, B2) et les première (D) et la deuxième (E) sous-cellules inférieures de sorte que la cellule solaire à au moins cinq jonctions est formée par l'assemblage, la première sous-cellule solaire supérieure (A1, A2), la deuxième sous-cellule solaire (C1, C2) et la troisième sous-cellule solaire (B1, B2) étant adaptées en courant, et la première sous-cellule inférieure (D) et la deuxième sous-cellule solaire inférieure (E) étant non-adaptée en courant aux sous-cellules solaires supérieure (A1, A2), deuxième (C1, C2) et troisième (B1, B2), dans lequel la sous-cellule inférieure (D, E) des premier (500) et deuxième (700) corps semi-conducteurs a un écart de bande dans la gamme d'environ 0,67 eV, la deuxième sous-cellule (C1, C2) des premier (500) et deuxième (700) corps semi-conducteurs a un écart de bande dans la gamme d'environ 1,41 eV à 1,31 eV, la troisième sous-cellule (B1, B2) des premier (500) et deuxième (700) corps semi-conducteurs a un écart de bande dans la gamme d'environ 1,65 à 1,8 eV et la première sous-cellule supérieure (A1, A2) des premier (500) et deuxième (700) corps semi-conducteurs a un écart de bande dans la gamme de 2,0 à 2,20 eV.

2. Un assemblage de cellules solaires multij onctions selon la revendication 1, comprenant en outre :
un premier contact électrique sur la première couche de conduction latérale, et un contact électrique sur la deuxième couche de conduction latérale, et dans lequel la connexion électrique est un fil soudé au premier contact électrique à une extrémité et au deuxième contact électrique à l'autre extrémité ; et
une connexion électrique entre le contact inférieur de la première sous-cellule inférieure et le contact supérieur de la deuxième sous-cellule inférieure.

3. Un assemblage de cellules solaires multijonctions selon la revendication 1, dans lequel
la première couche de conduction latérale dans chaque corps semi-conducteur (500, 700) est composée de InₓAl_{y}Ga_{1-x-y}As ou InₓGa₁₋ₓP avec 0 < x < 1, 0 < y < 1, et x et y sélectionné de telle sorte que l'écart de bande est dans la gamme de 1,41 eV à 1,6 eV et peut varier tout au long de son épaisseur, et est graduée en vue de composition pour être adaptée en réseau sensiblement à la deuxième sous-cellule solaire (C1, C2) d'un côté et la sous-cellule solaire inférieure (D, E) de l'autre côté.

4. L'assemblage de cellules solaires multijonctions selon la revendication 1, dans lequel:
la première sous-cellule supérieure (A1, A2) est composée de phosphure d'aluminium, de gallium et d'indium (InGaAlP);
la troisième sous-cellule solaire (B1, B2) comprend une couche d'émetteur composée de phosphure de gallium et d'indium (InGaP), d'arséniure de gallium, d'aluminium et d'indium (InAlGaAs) ou de phosphure et d'arséniure de gallium et d'indium (InGaAsP) et d'une couche de base composée d'arséniure de gallium, d'aluminium et d'indium ou de phosphure et d'arséniure de gallium et d'indium (InGaAsP);
la deuxième sous-cellule solaire (C1, C2) est composée d'arséniure de gallium et d'indium;
la quatrième sous-cellule est composée de germanium; et
la couche de conduction latérale est composée de InₓAl y_{y}Ga_{1-x-y}As ou InₓGa₁₋ₓP avec 0 < x < 1, 0 < y < 1, et x et y sélectionnés de telle sorte que l'écart de bande est dans la gamme de 1,41 eV à 1,6 eV et peut varier tout au long de son épaisseur.

5. L'assemblage de cellules solaires multijonctions selon la revendication 1, dans lequel la première sous-cellule supérieure (A1, A2) a un écart de bande dans la gamme de 2,0 à 2,20 eV et est composée de phosphure d'aluminium, de gallium et d'indium (InGaAlP);
la troisième sous-cellule solaire (B1, B2) a un écart de bande dans la gamme d'environ 1,65 à 1,8 eV et contient une couche d'émetteur composée de phosphure de gallium et d'indium (InGaP), d'arséniure de gallium, d'aluminium et d'indium (InAlGaAs) ou de phosphure et d'arséniure de gallium et d'indium (InGaAsP) et une couche de base composée d'arséniure de gallium, d'aluminium et d'indium ou de phosphure et d'arséniure de gallium et d'indium (InGaAsP);
la deuxième sous-cellule solaire (C1, C2) a un écart de bande dans la gamme de 1,3 à 1,41 eV et est composée d'arséniure de gallium et d'indium;
la quatrième sous-cellule est composée de germanium; la première sous-cellule supérieure est composée de phosphure d'aluminium, de gallium et d'indium.

6. Un assemblage de cellules solaires multijonctions selon la revendication 1, comprenant en outre:
une première couche réflecteur de Bragg distribuée (DBR) disposée au-dessus de la sous-cellule solaire inférieure et disposée de sorte que la lumière puisse entrer et passer à travers la sous-cellule solaire disposée sur la sous-cellule inférieure et dont au moins une partie peut être réfléchie dans la sous-cellule solaire située au-dessus de la sous-cellule inférieure par la couche DBR, et la couche réflecteur de Bragg distribuée est composée d'une pluralité de couches alternées de matériaux adaptés en réseau avec des discontinuités dans leurs indices de réfraction respectifs, dans lequel la différence dans les indices réfractions entre les couches alternées est maximisée afin de minimiser le nombre de périodes nécessaires pour atteindre une réflectivité donnée, et l'épaisseur et l'indice réfraction de chaque période détermine la bande d'arrêt et sa longueur d'onde limitante, et la couche DBR comprend une première couche DBR composée d'une pluralité de couches de p type et d'AlₓGa₁₋ₓ(In)As et une deuxième couche DBR disposée sur la première couche DBR et composée d'une pluralité de couches de type n ou p et d' Al_{y}Ga_{1-y}(In)As, où 0 < x < 1, 0 < y < 1, et y est plus grand que x, et le terme (In) désigne une inclusion facultative allant jusqu'à 10% d'indium.

7. Une cellule solaire multijonctions selon la revendication 6, comprenant en outre:
une deuxième couche de réflecteur Bragg distribuée (DBR) adjacente à la troisième et la quatrième sous-cellule solaire (D, E) et disposée de sorte que la lumière puisse entrer et passer à travers la troisième sous-cellule solaire (B1, B2) et au moins une partie de celle-ci peut être réfléchie dans la troisième sous-cellule solaire (B1, B2) par la couche DBR, et la couche réflecteur de Bragg distribuée est composée d'une pluralité de couches alternées de matériaux adaptés en réseau avec des discontinuités dans leurs indices respectifs de réfraction.

8. Un assemblage de cellules solaires multijonctions selon la revendication 1, dans lequel les premier et deuxième corps semi-conducteurs (500, 700) proviennent d'un seul corps semi-conducteur qui a été séparé pour former des corps séparés spatialement.

9. Une cellule solaire multijonction selon la revendication 1, dans lequel l'écart moyen de bande des quatre sous-cellules dans chacun des corps semi-conducteurs (c.-à-d. la somme des quatre écarts de bande directs ou indirects les plus bas des matériaux de chaque sous-cellule dans le corps semi-conducteur divisée par 4) est supérieur à 1,44 eV.

10. Un assemblage de cellules solaires multij onctions selon la revendication 1, comprenant en outre une première couche alpha déposée sur la première couche de conduction latérale à une épaisseur comprise entre 0,25 et 1,0 micron pour empêcher les dislocations de threading de se propager, soit en face de la direction de croissance ou dans le sens de la croissance dans la deuxième sous-cellule et comprenant en outre une deuxième couche alpha déposée sur la diode p-n de blocage ou la couche isolante à une épaisseur comprise entre 0,25 et 1,0 micron pour empêcher les dislocations de threading de se propager, soit en face de la direction de croissance ou dans le sens de la croissance dans la deuxième sous-cellule, comprenant en outre une diode de tunnel disposée sur la première couche de conduction latérale et sous la couche réflecteur de Bragg distribuée (DBR).

11. Un procédé de formation d'un module de cellule solaire contenant un terminal de première polarité et un terminal de deuxième polarité comprenant :
former un premier corps semi-conducteur (500) contenant une pile verticale tandem d'au moins une première sous-cellule solaire supérieure (A1), une deuxième sous-cellule solaire (C1), une troisième sous-cellule solaire (B1), qui sont adaptées en courant, et une quatrième sous-cellule solaire (D), la première sous-cellule supérieure (A1) ayant un contact supérieur relié au terminal de la première polarité et la quatrième sous-cellule solaire inférieure (D) étant non-adaptée en courant aux première (A1), deuxième (C1) et troisième (B1) sous-cellules solaires;
former un deuxième corps semi-conducteur (700) contenant une pile verticale tandem d'au moins une première sous-cellule supérieure (A2), une deuxième sous-cellule (C2) et une troisième sous-cellule (B2) et une quatrième sous-cellule solaire inférieure (E) qui est non-adaptée en réseau aux première (A2), deuxième (C2) et troisième (B2) sous-cellules solaires;
la densité de courant de court-circuit de la sous-cellule inférieure (D, E) étant au moins deux fois plus grande que celle des sous-cellules solaires (A1, A2, B1, B2, C1, C2) dans chaque pile parallèle qui sont reliées dans une série avec la sous-cellule inférieure (D, E);
disposer le premier corps semi-conducteur (500) adjacent au deuxième corps semi-conducteur (700) et relier le contact supérieur des premières sous-cellules supérieures (A1, A2) des premier et deuxième corps semi-conducteurs (500, 700);
relier la quatrième sous-cellule (D) du premier corps semi-conducteur (500) dans un circuit électrique de série à la quatrième sous-cellule (E) du deuxième corps semi-conducteur (700),
dans lequel le premier (500) et le deuxième corps semi-conducteur (700) comprennent chacun une première couche de conduction latérale hautement dopée (604, 704) reliée électriquement (803) les unes aux autres et disposée adjacente à et sous la deuxième sous-cellule solaire (C1, C2) de chaque corps respectif (500, 700);
et dans lequel le premier (500) et le deuxième corps semi-conducteur (700) comprennent chacun une diode p-n de blocage ou une couche isolante (602c, 702c) disposée adjacente à et sous la première couche de conduction latérale hautement dopée (604, 704); et une deuxième couche de conduction latérale hautement dopée (602b, 702b) disposée adjacente à et sous la diode p-n de blocage ou la couche isolante respective (602c, 702c),
une connexion électrique (802, 803) entre la première couche de conduction latérale (604, 704) du deuxième corps semi-conducteur (700) et la deuxième couche de conduction latérale (602b) du premier corps semi-conducteur;
la sous-cellule solaire inférieure (D, E) de chaque corps respectif (500, 700) étant disposé adjacente à et sous la deuxième couche de conduction latérale hautement dopée (602b, 702b), la sous-cellule inférieure (D) du premier corps semi-conducteur (500) étant reliée dans un circuit électrique de série à la sous-cellule inférieure (E) du deuxième corps semi-conducteur (700) de sorte qu'au moins une cellule solaire à quatre jonctions est formée par l'assemblage,
et dans lequel la première couche de conduction latérale (604, 704) dans chacun des premier et deuxième corps semi-conducteurs (500, 700) est graduée en composition pour être adaptée en réseau sensiblement à la deuxième sous-cellule solaire d'un côté et à la sous-cellule solaire inférieure de l'autre côté, et est composée de l'un des semi-conducteurs de composés III - V à base d'As, P, N, Sb, soumis aux contraintes d'avoir le paramètre de réseau en plan inférieur ou égal à celui de la deuxième sous-cellule solaire et supérieur ou égal à celui de la cellule solaire inférieure;
dans lequel la première sous-cellule solaire supérieure (A1, A2), la deuxième sous-cellule solaire (C1, C2) et la troisième sous-cellule solaire (B1, B2) sont adaptées en courant, et les sous-cellules (D, E) sont non-adaptée en réseau aux première sous-cellules solaires supérieure (A1, A2), deuxième sous-cellules solaires (C1, C2) et troisième sous-cellules solaires (B1, B2), dans lequel la sous-cellule inférieure (D, E) des premier et deuxième corps semi-conducteurs (500, 700) a un écart de bande dans la gamme d'environ 0,67 eV, la deuxième sous-cellule (C1, C2) des premier et deuxième corps semi-conducteurs (500, 700) a un écart de bande dans la gamme d'environ 1,41 eV à 1,31 eV, la troisième sous-cellule (B1, B2) des premier et deuxième corps semi-conducteurs (500, 700) a un écart de bande dans la gamme d'environ 1,65 à 1,8 eV et la première sous-cellule supérieure (A1, A2) dees premier et deuxième corps semi-conducteurs (500, 700) a un écart de bande dans la gamme de 2,0 à 2,20 eV.
